(19) Europäisches Patentamt
European Patent Office
Office européen des brevets

(11) **EP 0 562 217 B1**

(12) **EUROPEAN PATENT SPECIFICATION**

(45) Date of publication and mention
of the grant of the patent:
**28.05.1997 Bulletin 1997/22**

(51) Int Cl.$^6$: **H01L 29/735**, H01L 29/08,
H01L 27/06, H01L 21/8249

(21) Application number: **92830153.0**

(22) Date of filing: **27.03.1992**

(54) **Lateral bipolar transistor with a low current leakage toward the substrate, corresponding integrated circuit and method of making such an integrated circuit**

Lateraler Bipolartransistor mit niedrigem Leckstrom zum Substrat, entsprechende integrierte Schaltung und Verfahren zur Herstellung einer solchen integrierten Schaltung

Transistor latéral à faible courant de fuite vers le substrat, circuit intégré correspondant et méthode de fabrication d'un tel circuit intégré

(84) Designated Contracting States:
**DE ES FR GB IT SE**

(43) Date of publication of application:
**29.09.1993 Bulletin 1993/39**

(73) Proprietor: **SGS-THOMSON MICROELECTRONICS S.r.l.**
**20041 Agrate Brianza (Milano) (IT)**

(72) Inventors:
• **Siligoni, Marco**
**20010 Vittuone (IT)**
• **Ferrari, Paolo**
**21013 Gallarate (IT)**

(74) Representative: **Pellegri, Alberto et al**
**c/o Società Italiana Brevetti S.p.A.**
**Via Puccini, 7**
**21100 Varese (IT)**

(56) References cited:
**EP-A- 0 405 045**　　　　**US-A- 4 812 891**

• **PATENT ABSTRACTS OF JAPAN vol. 14, no. 18 (E-873) 16 January 1990; & JP-A-12 61 865**
• **PATENT ABSTRACTS OF JAPAN vol. 11, no. 212 (E-522) 9 July 1987; & JP-A-62 035 566**

## Description

The present invention relates to a lateral bipolar transistor which may be monolithically integrated in an epitaxial layer of a device having an architecture with a junction-type isolation among different components and, more in particular, to a lateral bipolar transistor structure which is particularly suited to be integrated in so-called mixed technology devices, such as: BCMOS, BCT, BIPOLAR/I$^2$L, as well as in purely bipolar technology devices.

Mixed technology integrated circuits are finding growing opportunities of utilization because of their outstanding versatility. On the other hand the quest for an ever increasing density of these integrated devices in order to enhance miniaturization of the systems aggravates compatibility problems in forming different technology structures such as bipolar transistors and MOS (CMOS) transistors, monolithically integrated in the same chip.

In particular, the realization of high density, mixed technology integrated circuits necessarily implies, according to modern fabrication processes, a drastic reduction of junction depths (i.e. shallower diffusions). This fact, while bringing important advantages in making effective CMOS structures, tends to penalize electrical efficiency and Early voltage characteristics of lateral bipolar transistors. In fact, in first-generation, mixed technology integrated circuits, wherein the field oxide was patterned after its growth and wherein the junction depth remained relatively large (e.g. from 3 to 4 μm for p$^+$ diffusions), the efficiency of lateral bipolar transistors remained satisfactory, but the integrated structures could not be made very dense. Vice versa in mixed technology integrated circuits made in accordance with the most modern techniques, which contemplate the growth of the field oxide on areas pre-defined by means of a silicon nitride mask and the formation in a self-alignment mode of superficially enriched well regions, a high density of the integrated structures may be obtained, though accompanied by a consistent loss of electrical efficiency of lateral bipolar transistors because of a dramatically increased leakage of collector current toward the isolation junctions (and the substrate) which surround the transistor region.

Moreover, the fabrication processes of bipolar transistors in integrated circuits represent a development of the processes used for fabricating epitaxial, double-diffusion, NPN transistors and while this permits the realization of NPN transistors with excellent characteristics it conversely renders much more difficult to realize PNP transistors with comparable characteristics, because these devices utilize as a base region the lightly doped n-type epitaxial layer. Therefore, in integrated circuits, it is often the structure of a lateral PNP transistor which causes a remarkable leakage of current toward the substrate, which behaves as a collector of a parasitic "vertical" PNP transistor. Indeed the formation of an n-type buried layer generates an electric field which tends to inhibit this current leakage mechanism however a nonnegligeable degradation of the transistor's gain remains.

The most general need for a lateral bipolar transistor having an improved structure stems in practice from the necessity of having an output impedance as high as possible for a grounded-base configured transistor while reducing the current leakage in the emitter-collector path.

In a prior patent application: EP-A-0 405 045, in the name of the same Applicant, an original structure of an integrated lateral bipolar transistor having improved characteristics of current leakage is disclosed. Basically, the structure disclosed in this prior publication is characterized by the presence of an annular collector region having a diffusion profile different from and deeper than the diffusion profile of the emitter region which is formed concentrically inside the epitaxial region surrounded by the annular collector region. In practice, the emitter region is formed through a standard diffusion while the collector region is formed by a well-type diffusion. Such a structure effectively reduces the current leakage toward the substrate however the nonuniformity between the diffusion profiles of the collector and emitter regions determines the loss of significant advantages which are intrinsic to the standard structure of the lateral bipolar transistor wherein the base region is advantageously self-aligned by virtue of the fact that the emitter and collector regions are simultaneously formed, i.e. the emitter region and the collector region are defined by the same photolithographic step (i.e. by the same mask) and therefore the two regions are perfectly self-aligned in respect to each other. The loss of self-alignment in the structure proposed in the above-identified prior European patent application, introduces an additional tolerance in the actual definition of the base region of the transistor and this is reflected in an increased spread of the electrical parameters of the transistor: i.e. of the current gain and cut-off frequency. This increased spread of parameters may be intolerable in many applications, especially in complex integrated circuits with a high density of integration, wherein this reduced precision may raise design problems diffult to be solved.

An effective solution to the problem of current leakage toward the substrate of a lateral bipolar transistor, having the attendant advantage of preserving the self-alignment of the base region which is intrinsic of a standard structure of the transistor (i.e. the ability to form the emitter and collector regions in a self-alignment way) has been found.

A lateral bipolar transistor in accordance with the present invention is defined in claim 1. An integrated circuit comprising said transistor is furthermore defined in claim 4, and a method of fabricating such an integrated circuit is defined in claim 8.

Basically, the structure of a lateral bipolar transistor of the present invention maintains self-alignment between the emitter and collector regions which maintain identical conductivity characteristics (i.e. same diffusion profile), while a second outer annular region having a lower doping level and a greater depth than that of an inner annular collector region and being electrically shortcircuited with the latter, intercepts the path of minority carriers injected into the base region toward the isolation diffusions, thus reducing the leakage of current toward the substrate. In a grounded-base configuration, the transistor made in accordance with the present invention has an output impendance which is practically twice the output impedance of a comparable transistor having a standard structure while the leakage of current toward the substrate is halved.

The different aspects and advantages of the invention will be more easily recognized through the following description of an embodiment having a purely illustrative and nonlimitative function, the scope of the invention being defined by the appended claims.

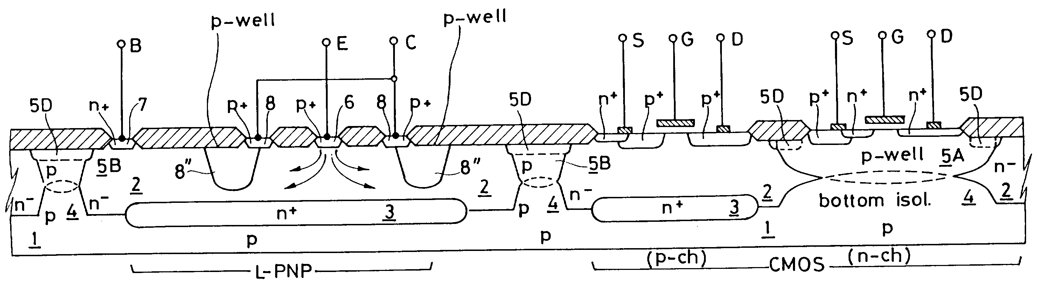

The attached figure is a fragmentary schematic cross section of a high density, mixed technology, integrated device containing a lateral bipolar transistor made in accordance with the present invention.

As shown in the figure, a high density of integration, mixed technology, integrated circuit may comprise, according to the chosen illustrative example, a substrate 1 of monocrystalline p-type silicon, doped with boron and having a bulk resistivity which may be comprised between 10 and 20 ohm x cm, onto which an epitaxially grown $n^-$-type layer 2 is present. The $n^+$-type buried layers 3 and the bottom-isolation p-type diffusions 4 may be formed according to standard fabrication techniques of these types of integrated devices.

According to the same well known fabrication techniques, predefined areas of the surface of the epitaxial layer 2 are implanted with boron in order to form, through a subsequent diffusion of the implanted boron atoms, p-type doped well regions 5A, which may be notably used as body regions into which n-channel transistors of CMOS structures are formed and eventually also as base regions for NPN lateral bipolar transistors (not depicted in the figure) and further used as top-isolation diffusions 5B which intercept with corresponding bottom-isolation diffusions 4, in order to constitute in practice isolation walls of p-type silicon around the active area of different semiconductor devices.

Functionally, the structure of a lateral PNP transistor is constituted by the emitter region 6, which is spaced from and surrounded by the annular collector region 8. The two regions are self-aligned among each other by being formed by a diffused $p^+$-type region having the same diffusion profile because they are produced simultaneously through the same definition steps. An $n^+$ base contact region 7, formed in the epitaxial layer outside the annular collector region, completes the functional structure of the lateral bipolar transistor.

In accordance with the present invention, a second p-type outer annular region 8" is formed around the annular collector region 8. This second annular region may have the same diffusion profile as that of a p-well 5A (or that of a top isolation 5B). According to a preferred embodiment of the invention depicted in the figure, this second outer annular region 8", having a p-well diffusion profile, intercepts the outermost portion of the annular collector region 8 and may extend laterally, at least partially, underneath the thick dielectric layer of field oxide which defines the outer perimeter of the annular collector region 8.

Optionally an enriched zone, known also as "channel stopper region" may be advantageously formed in the top portion of the second outer annular region 8", similarly to what is depicted as an enrichment region 5D in the uppermost portion of the other p-well type regions shown in the figure, namely: 5A and 5B.

Essentially this second outer annular region 8" is electrically connected in common with the annular collector region 8 to the collector terminal C of the transistor and, similarly to the other p-well regions 5A and 5B, extends in the epitaxial layer 2 deeper than the collector region 8, e.g. by a depth which may be comprised between 4 and 6 $\mu$m, thus constituting an effective barrier against the dispersion of emitter current (the accelerated motion of minority carriers, that is of injected holes, being symbolically shown in the figure by the arrows) toward the adjacent isolation junctions 5B and 4 and finally toward the substrate 1.

On the other hand, the emitter region 6 and the collector region 8 are self-aligned regions, i.e. regions which are defined and formed through the same steps of the fabrication process (same mask, same implantation, same diffusion), therefore the self-alignment of the base channel ($p^+$ versus $p^+$) of the transistor is as in a standard structure, i.e. in a structure having no means for intercepting the leakage emitter current toward the substrate.

The fabrication process for realizing a lateral bipolar transistor structure of the present invention differs from a standard fabrication process by the fact that together or after having implanted the dopant in the top isolation areas, the same dopant is implanted in defined well areas as well as in a defined annular area adjacent to the geometric projection of the definition edge of the field oxide layer which will eventually define the outer perimeter of an annular collector area of a lateral bipolar transistor, so that, upon a subsequent thermal diffusion treatment, the outer annular region 8", having the same diffusion profile as that of a well-region, is formed. Moreover, it will be possible to preliminarily perform also on said outer annular region (8") areas, an enrichment implantation of dopant which may be contemplated by the normal fabrication process for forming in a self-alignment manner superficial enriched regions (channel stopper) above the top isolation diffusions 5B and above the well region diffusions 5A (identified with 5D in the figure).

After having simultaneously formed together with the "body" and top isolation regions also the outer annular regions 8'' and after having grown the field oxide layer, the fabrication process may continue through a normal sequence of steps to the end.

As will be evident to a skilled technician, what has been described in detail for the example depicted in the figure is equally applicable to the case of a lateral bipolar NPN transistors in the context of a similar mixed technology integrated circuit wherein all the types of conductivity and polarity are reversed as compared to those of the depicted example.

Moreover to the same skilled technician, the ranges of variation of the doping levels of the various regions of the semiconducting silicon will be similarly well known: the indication: p-type silicon representing substantially a silicon region lightly doped with boron, while a $p^+$-type region representing a region heavily doped with boron. Similarly, the epitaxial layer having a relatively low electrical conductivity is indicated as being an $n^-$-type silicon region, e.g. a region lightly doped with phosphorous, while the $n^+$ regions represent regions heavily doped with arsenic or phosphorous or antimony in accordance with a symbology which is readily understood by a technician, notwithstanding the fact that the corresponding actual doping levels may vary within certain limits which are also well known and documented in the pertinent literature.

Through a comparative analysis of the electrical behaviour of an integrated lateral bipolar PNP transistor with and without a second outer annular region electrically connected in common with the annular collector region to the respective terminal of the transistor, in accordance with the present invention, the following results were obtained:

a) for a standard PNP structure:
$$\beta o = 400 \qquad n = 200$$

$$R_{OUT} = \frac{\beta o \, n}{\beta o + n} \times Ro = 133 \, Ro$$

b) for a comparable PNP structure provided with a second outer annular region with a p-well profile, in accordance with the present invention:
$$\beta o = 400 \qquad n = 100$$

$$R_{OUT} = \frac{\beta o \, n}{\beta o + n} \times Ro = 286 \, Ro$$

where:

$$\beta o = \frac{I_C + I_S}{I_B} \qquad n = I_C / I_S \qquad Ro = V_A / I_C$$

and

$I_C =$ collector current

$I_B =$ base current

$I_S =$ substrate current

$V_A =$ Early voltage

The improved lateral bipolar transistor structure made in accordance with the present invention has an output impedance ($R_{OUT}$) which is about twice the output impedance of a standard structure (Ro) and the improved output impedance and gain characteristics are combined with a halving of the current leakage toward the substrate as compared with a standard structure not provided with the outer annular region shortcircuited with the collector's region.

## Claims

1. A lateral bipolar transistor located in an epitaxial semiconducting layer (2) which constitutes a base region of the transistor and comprising an emitter region (6) spaced from and surrounded by an annular collector region (8) having a conductivity of a type opposite to the type of conductivity of said epitaxial layer (2) and a base contact region (7) in said epitaxial layer (2) outside said annular collector region (8), wherein

said annular collector region (8) is heavily doped and has the same doping profile as that of said emitter region (6), and

said annular collector region (8) is surrounded by an outer annular region (8'') which has a lower doping level than that of said annular collector region (8), and which does not intercept the innermost portion of the annular collector region (8) and extends to a greater depth into said epitaxial layer (2) than said annular collector region (8),

said outer annular region (8'') being electrically connected in common with said annular collector region (8) to a collector terminal (C) of the transistor.

2. A transistor as defined in claim 1, wherein said outer annular region (8'') intercepts the outermost portion of said annular collector region (8).

3. A transistor as defined in claim 1, wherein the transistor is a PNP transistor.

4. An integrated circuit monolithically integrated in an epitaxial semiconducting layer (2) of lightly doped silicon of a first type of conductivity disposed on a monocrystalline, lightly doped silicon substrate (1) of a second type of conductivity and comprising complementary, surface-type field-effect transistors consisting of a first field-effect transistor having source and drain regions of said first type of conductivity, located in a well region (5A) of said second type of conductivity disposed in a first region of said epitaxial layer (2), and of a second field-effect transistor, having source and drain regions of said second type of conductivity, located in a second region of said epitaxial layer (2), and at least a lateral bipolar transistor, said lateral bipolar transistor being as claimed in claim 1 and located in a third region of said epitaxial layer (2), electrically isolated from said substrate by a heavily doped buried layer (3) of said first type of conductivity present at the bottom of said third region and laterally by bottom isolation regions (4) and top isolation regions (5B) merging so as to form walls of doped silicon of said second type of conductivity extending through the entire thickness of said epitaxial layer (2) around said third region, said lateral bipolar transistor comprising a heavily doped, base contact region (7) of said first type of conductivity, a heavily doped emitter region (6) of said second type of conductivity and a heavily doped, annular collector region (8) of said second type of conductivity surrounding said emitter region (6) and spaced therefrom; said base contact region (7) having the same doping profile as that of the source and drain regions of said first field-effect transistor, and said emitter (6) and collector (8) regions having the same doping profile as that of the source and drain regions of said second field-effect transistor, and

an outer annular region (8") of said second type of conductivity as defined in claim 1 having the same doping profile as that of said top isolation regions (5B) and/or of said well region (5A).

5. An integrated circuit as defined in claim 4, wherein said outer annular region (8") intercepts the outermost portion of said annular collector region (8).

6. An integrated circuit as defined in claim 4, wherein said substrate (1) has a p-type conductivity, said epitaxial layer (2) has a n⁻-type conductivity, said lateral bipolar transistor is a PNP transistor, said well region (5A) has a p-type conductivity, and said outer annular region (8") has the same doping profile as that of said well region (5A).

7. An integrated circuit according to claim 6, wherein a surface portion of said outer annular region (8") is boron enriched, whereby a channel stopper region is formed.

8. A method of fabricating an integrated circuit as claimed in any one of claims 4 to 7, monolithically integrated in an n- epitaxial semiconducting layer (2) formed on a p-type monocrystalline silicon substrate (1) and comprising complementary field-effect transistors and a lateral bipolar transistor as defined in claim 4 and being a PNP bipolar transistor, said method comprising implanting antimony or arsenic and boron on respectively defined areas on the surface of said p-type substrate (1), thereby forming buried layers (3) and bottom isolation regions (4), respectively, growing said n- type epitaxial layer (2), depositing and patterning a masking layer of silicon nitride on said epitaxial layer (2), growing over silicon areas unmasked by said patterned nitride layer a field oxide layer by oxidizing the surface of said epitaxial layer (2), implanting boron in defined areas of the surface of said oxidized epitaxial layer (2), thereby forming top isolation regions (5B) intercepting said bottom isolation regions (4), and p-well regions (5A) as body regions into which n-channel field-effect transistors of said complementary field-effect transistors are formed and as base regions for lateral bipolar NPN transistors, and simultaneously also in an annular area near the perimeter of a circular opening provided in said field oxide layer, thereby forming the outer annular collector region (8") of said lateral PNP bipolar transistor.

**Patentansprüche**

1. Lateralbipolartransistor, angeordnet in einer epitaxialen halbleitenden Lage (2), welche einen Basisbereich des Transistors bildet, und umfassend einen Emitterbereich (6), beabstandet von und umgeben durch einen ringförmigen Kollektorbereich (8), welcher eine Leitfähigkeit des entgegengesetzten Types zu dem Typ der Leitfähigkeit der Epitaxiallage (2) aufweist, und einen Basiskontaktbereich (7) in der Epitaxiallage (2), außerhalb des ringförmigen Kollektorbereichs (8), bei welchem

der ringförmige Kollektorbereich (8) stark dotiert ist und dasselbe Dotierungsprofil aufweist wie der Emitterbereich (6), und

der ringförmige Kollektorbereich (8) umgeben ist durch einen äußeren ringförmigen Bereich (8"), welcher einen niedrigeren Dotierungspegel aufweist als der ringförmige Kollel<torbereich (8), und welcher den innersten Abschnitt des ringförmigen Kollektorbereiches (8) nicht schneidet und sich auf eine größere Tiefe in der Epitaxiallage (2) erstreckt als der ringförmige Kollektorbereich (8),

wobei der äußere ringförmige Bereich (8") elektrisch gemeinsam mit dem ringförmigen Kollektorbereich (8) verbunden ist mit einem Kollektoranschluß (C) des Transistors.

**2.** Transistor nach Anspruch 1, bei welchem der äußere ringförmige Bereich (8") den äußersten Abschnitt des ringförmigen Kollektorbereiches (8) schneidet.

**3.** Transistor nach Anspruch 1, bei welchem der Transistor ein PNP-Transistor ist.

**4.** Integrierte Schaltung, monolithisch integriert in einer epitaxialen halbleitenden Lage (2) von leicht dotiertem Silicium eines ersten Types von Leitfähigkeit, angeordnet an einem monokristallinen leichtdotierten Siliciumsubstrat (1) eines zweiten Types von Leitfähigkeit, und umfassend ergänzend Oberflächentypfeldeffekttransistoren, bestehend aus einem ersten Feldeffekttransistor mit Source- und Drainbereichen des ersten Types von Leitfähigkeit, angeordnet in einem Donatorbereich (5A) des zweiten Types von Leitfähigkeit, angeordnet in einem ersten Bereich der Epitaxiallage (2), und aus einem zweiten Feldeffekttransistor mit Source- und Drainbereichen des zweiten Types von Leitfähigkeit, angeordnet in einem zweiten Bereich der Epitaxiallage (2), und zumindest einen Lateralbipolartransistor, wobei der Lateralbipolartransistor gemäß Anspruch 1 vorliegt und angeordnet ist in einem dritten Bereich der Epitaxiallage (2), elektrisch isoliert von dem Substrat durch eine stark dotierte vergrabene Lage (3) des ersten Types von Leitfähigkeit, vorhanden an dem Boden des dritten Bereiches, und lateralwärts durch Bodenisolationsbereiche (4) und obere Isolationsbereiche (5B) so vorgesehen, daß Wände von dotiertem Silicium des zweiten Types von Leitfähigkeit gebildet sind, sich über die gesamte Dicke der Epitaxiallage (2) um den dritten Bereich erstreckend, wobei der Lateralbipolartransistor umfaßt einen stark dotierten Basiskontaktbereich (7) des ersten Types von Leitfähigkeit, einen stark dotierten Emitterbereich (6) des zweiten Types von Leitfähigkeit und einen stark dotierten ringförmigen Kollektorbereich (8) des zweiten Types von Leitfähigkeit, welcher den Emitterbereich (6) umgibt und davon beabstandet ist, wobei der Basiskontaktbereich (7) dasselbe Dotierungsprofil aufweist wie die Source- und Drainbereiche des ersten Feldeffekttransistors, und wobei die Emitter- (6) und Kollektor- (8)bereiche dasselbe Dotierungsprofil aufweisen wie die Source- und Drainbereiche des zweiten Feldeffekttransistors, und einen äußeren ringförmigen Bereich (8") des zweiten Types von Leitfähigkeit, wie definiert in Anspruch 1, mit demselben Dotierungsprofil wie der obere Isolationsbereich (5B) und/oder der Donatorbereich (5A).

**5.** Integrierte Schaltung nach Anspruch 4, bei welcher der äußere ringförmige Bereich (8") den äußersten Abschnitt des ringförmigen Kollektorbereiches (8) schneidet.

schneidet.

**6.** Integrierte Schaltung nach Anspruch 4, bei welcher das Substrat (1) eine p-Typ Leitfähigkeit, die Epitaxiallage (2) eine n⁻-Typ Leitfähigkeit, der Lateralbipolartransistor ein PNP-Transistor ist, der Donatorbereich (5A) eine p-Typ Leitfähigkeit und der äußere ringförmige Bereich (8") dasselbe Dotierungsprofil aufweist wie der Donatorbereich (5A).

**7.** Integrierte Schaltung nach Anspruch 6, bei welcher ein Flächenabschnitt des äußeren ringförmigen Bereiches (8") Bor-angereichert ist, wodurch ein Kanal-Stoppbereich gebildet ist.

**8.** Herstellungsverfahren einer integrierten Schaltung nach einem der Ansprüche 4 bis 7, monolithisch integriert in einer n⁻-epitaxial halbleitenden Lage (2), gebildet an einem p-Typ monokristallinen Siliciumsubstrat (1), und umfassend ergänzend Feldeffekttransistoren und einen Lateralbipolartransistor nach Anspruch 4, welcher ein PNP-Bipolartransistor ist, wobei das Verfahren umfaßt Implantieren von Antimon oder Arsen und Bor an jeweils definierten Bereichen an der Fläche des p-Typ Substrates (1), somit vergrabene Lagen (3) bzw. Bodenisolationsbereiche (4) bildend, Züchten der n⁻-Typ Epitaxiallage (2), Ablagern bzw. Fällen und Mustern einer Maskierlage aus Siliciumnitrid an der Epitaxiallage (2), Züchten bzw. Anwachsen über durch die gemusterte Nitridlage unmaskierte Siliciumbereiche einer Feldoxidlage durch Oxidieren der Fläche der Epitaxiallage (2), Implantieren von Bor in definierten Bereichen der Fläche der oxidierten Epitaxiallage (2), somit bildend obere Isolationsbereiche (5B), welche die Bodenisolationsbereiche (4) schneiden, und p-Donatorbereiche (5A) als Körperbereiche, in welchen n-Kanal Feldeffekttransistoren des komplementären Feldeffekttransistors gebildet sind und als Basisbereiche für Lateralbipolar-NPN-Transistoren, und gleichzeitig ebenfalls in einem ringförmigen Bereich nahe dem Perimeter einer kreisförmigen Öffnung, bereitgestellt in der Feldoxidlage, wodurch der äußere ringförmige Kollektorbereich (8") des Lateralbipolar-PNP-Transistors gebildet wird.

**Revendications**

**1.** Transistor bipolaire latéral disposé dans une couche semiconductrice épitaxiale (2) qui constitue une région de base du transistor et comprenant une région d'émetteur (6) entourée par et espacée d'une région de collecteur annulaire (8) d'un type de conductivité opposé au type de conductivité de la couche épitaxiale (2) et une région de contact de base (7) dans la couche épitaxiale (2) à l'extérieur de la région de collecteur annulaire (8), dans lequel :

la région de collecteur annulaire (8) est fortement dopée et a le même profil de dopage que celui de la région d'émetteur (6),

la région de collecteur annulaire (8) est entourée d'une région annulaire externe (8") qui a un plus faible niveau de dopage que celui de la région de collecteur annulaire (8) et qui ne coupe pas la partie la plus interne de la région de collecteur annulaire (8) et s'étend sur une plus grande profondeur dans la couche épitaxiale (2) que la région de collecteur annulaire (8),

la région annulaire externe (8") est électriquement connectée, avec la région de collecteur annulaire (8), à une borne de collecteur (C) du transistor.

2. Transistor selon la revendication 1, dans lequel la région annulaire extérieure (8") coupe la partie externe de la région de collecteur annulaire (8).

3. Transistor selon la revendication 1, dans lequel le transistor est un transistor PNP.

4. Circuit intégré monolithique dans une couche semiconductrice épitaxiale (2) de silicium faiblement dopé d'un premier type de conductivité disposée sur un substrat de silicium monocristallin faible dopé (1) d'un second type de conductivité et comprenant des transistors à effet de champ complémentaires du type en surface consistant en un premier transistor à effet de champ ayant des régions de source et de drain du premier type de conductivité disposées dans une région de caisson (5A) du second type de conductivité disposée dans une première région de la couche épitaxiale (2) et en un second transistor à effet de champ ayant des régions de source et de drain du second type de conductivité, disposées dans une seconde région de la couche épitaxiale (2), et au moins un transistor bipolaire latéral, ce transistor bipolaire latéral étant tel que revendiqué en revendication 1, et disposé dans une troisième région de la couche épitaxiale (2), électriquement isolée du substrat par une couche enterrée fortement dopée (3) du premier type de conductivité présente au fond de la troisième couche et, latéralement, par des régions d'isolement inférieure (4) et supérieure (5B) se rejoignant pour former des murs de silicium dopé du second type de conductivité s'étendant sur toute l'épaisseur de la couche épitaxiale (2) autour de la troisième région, le transistor bipolaire latéral comprenant une région de contact de base (7) fortement dopée du premier type de conductivité, une région d'émetteur (6) fortement dopée du second type de conductivité et une région de collecteur annulaire (8) fortement dopée du second type de conductivité entourant la région d'émetteur (6) et espacée de celle-ci, la région de contact de base (7) ayant le même profil de dopage que les régions de source et de drain du premier transistor à effet de champ et les régions d'émetteur (6) et de collecteur (8) ayant le même profil de dopage que les régions de source et de drain du second transistor à effet de champ, et

une région annulaire externe (8") du second type de conductivité telle que définie en revendication 1 ayant le même profil de dopage que les régions d'isolement supérieures (5B) et/ou la région de caisson (5A).

5. Circuit intégré selon la revendication 4, dans lequel la région annulaire externe (8") coupe la partie externe de la région de collecteur annulaire (8).

6. Circuit intégré selon la revendication 4, dans lequel le substrat (1) est du type de conductivité P, la couche épitaxiale (2) de type de conductivité N⁻, le transistor bipolaire latéral est un transistor PNP, la région de caisson (5A) est du type de conductivité P, et la région annulaire externe (8") a le même profil de dopage que la région de caisson (5A).

7. Circuit intégré selon la revendication 6, dans lequel une partie superficielle de la région annulaire externe (8") est enrichie au bore, d'où il résulte qu'une région d'arrêt de canal est formée.

8. Procédé de fabrication d'un circuit intégré selon l'une quelconque des revendications 4 à 7, formé de façon monolithique dans une couche semiconductrice épitaxiale N⁻ (2) formée sur un substrat de silicium monocristallin de type P (1) et comprenant des transistors à effet de champ complémentaires et un transistor bipolaire latéral tel que défini en revendication 4, ce transistor étant un transistor bipolaire PNP, ce procédé consistant à implanter de l'antimoine ou de l'arsenic et du bore sur des zones définies de façon respective sur la surface du substrat de type P (1), formant ainsi des couches enterrées (3) et des régions d'isolement de fond (4), respectivement ; faire croître la couche épitaxiale de type N⁻ (2) ; déposer et graver une couche de masquage de nitrure de silicium sur la couche épitaxiale (2) ; faire croître sur les zones de silicium non-masquées par la couche de nitrure gravée une couche d'oxyde de champ en oxydant la surface de la couche épitaxiale (2) ; implanter du bore dans des zones définies de la surface de la couche épitaxiale oxydée (2), formant ainsi des régions d'isolement supérieures (5B) rejoignant les régions d'isolement inférieures (4), et des régions de caisson P (5A) en tant que régions de substrat dans lesquelles sont formés les transistors à effet de champ à canal N desdits transistors à effet de champ complémentaires, et en tant que régions de base pour les transistors bipolaires NPN latéraux, et simultanément également dans une zone annulaire proche du périmètre d'une ouverture circulaire formée dans la couche d'oxyde de champ, formant ainsi la région de collecteur annulaire externe (8") du transistor bipolaire PNP latéral.